# EUROPEAN PATENT APPLICATION

(11) **EP 3 499 648 A1**
(43) Date of publication of application: **19.06.2019**
(21) Application number: 18206897.3
(22) Date of filing: 19.11.2018
(51) Int. Cl.: H01R 12/57, H01R 12/70, H01R 12/71, H01R 13/516, H05K 5/00, H01R 12/72

(54) **CONNECTOR STRUCTURE**

(30) Priority: 18.12.2017 JP 2017241924
(71) Applicant: Valeo Japan Co., Ltd., Saitama 360-0193 (JP)
(72) Inventor: SAKURAI, Junichi, Tokyo, 143-8521 (JP); KIMURA, Shigeki, Tokyo, 143-8521 (JP)
(74) Representative: Oppermann, Frank

(57) **Abstract**

There is provided a connector structure that prevents positional accuracy of a housing 55 and a terminal part 51 for a connector attached to a switch and positional accuracy of an electronic component from being reduced while reducing manufacturing costs of the switch.

A case 1 includes a case body 11 for accommodating an electronic substrate 7 therein and a cover 15 for closing a lower end opening of the case body 11. A connector 5 includes a terminal part 51 for supporting a pin-shaped terminal and a housing 55 including a tubular part for surrounding a tip end side 58a of the pin-shaped terminal. The terminal part 51 and the housing 55 are separately disposed, the terminal part is 51 fixed on the electronic substrate 7, the housing 55 is formed to be integral with the cover 15, and the terminal part 51 and the housing 55 are respectively provided with a through hole 53a and a groove 53b, and projections 57 for positioning the terminal part 51 and the housing 55 with each other.

## Description

### BACKGROUND OF THE INVENTION

### Field of the Invention

The present invention relates to a connector structure.

### Description of the Related Art

An electronic component of a switch or the like that is mounted on a vehicle is connected electrically to a battery, a control device and the like at a vehicle side using a connector (for example, refer to WO2017/032638).

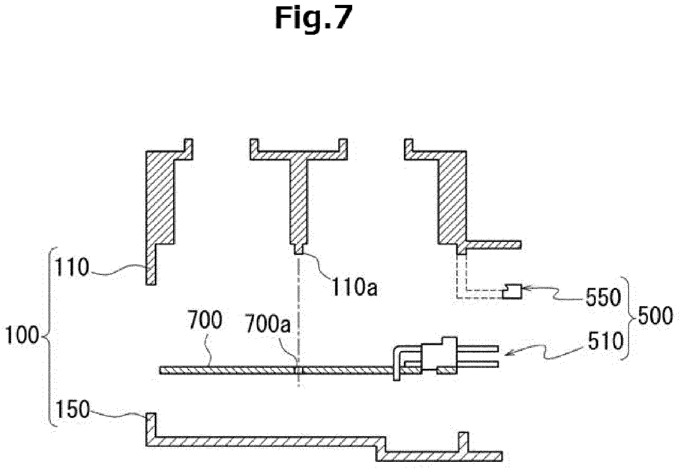

Fig. 7 is a diagram explaining the assembling of a switch provided with a conventional connector structure.

As illustrated in Fig. 7, an electronic component is provided with an electronic substrate 700 and a case 100. The case 100 is provided with a case body 110 for accommodating the electronic substrate 700 therein and a cover 150 for closing an opening of the case body 110. A connector 500 at the electronic component side is provided with a terminal part 510 supporting a plurality of terminals and a tubular housing 550 surrounding tip end sides of the plurality of terminals. A connector (unillustrated) at a vehicle side is inserted from an opened tip end side of the housing, and is connected to a connector at the electronic component side.

The terminal part 510 of the connector 500 and the housing 550 are usually formed integrally, but a separate formation of the terminal part 510 and the housing 550 has been proposed for cutting down on manufacturing costs. In the example in Fig. 7, the terminal part 510 and the housing 550 are formed separately and the housing 550 is formed to be integral with the case body 110. The terminal part 510 is in advance fixed on the electronic substrate 700 by soldering or the like, and then the electronic substrate 700 is accommodated in the inside of the case body 110 from the opening of the case body 110. The electronic substrate 700 and the case body 110 are positioned by respective positioning parts 110a, 700a to be mounted. The opening of the case body is covered with the cover 150, preventing intrusion of dusts and the like.

### SUMMARY OF THE INVENTION

In a case where the terminal part 510 of the connector 500 and the housing 550 are separately formed, since the terminal part 510 of the connector 500 and the housing 550 are positioned through the electronic substrate 700 and the case body 110 connected thereto respectively, each positional accuracy possibly gets lower as compared to a case of being integrally formed. When the positional accuracy of the terminal part 510 and the housing 550 is reduced, at the time of inserting the connector at the vehicle side from the tip end of the housing 550 to be connected to the terminal part 510 of the connector 500, there is a possibility that required positional accuracy cannot be achieved.

For enhancing the positional accuracy of the terminal part 510 and the housing 550, it is considered to cause the case body 110, which has been positioned with respect to the electronic substrate 700, to be positioned directly with respect to the terminal part 510. However, in that case, there is a possibility that the positional accuracy of the case body 110 and the electronic substrate 700 is reduced to reduce positional accuracy of the electronic component of the switch or the like.

Accordingly, the present invention is made in view of the above-described problems, and an object of the present invention is to provide a connector structure that prevents positional accuracy of a housing and a terminal part for a connector attached to a switch and positional accuracy of an electronic component from being reduced while reducing manufacturing costs of the switch.

According to an aspect of the present invention, a connector structure in a case in which a connector is attached comprises:
the case including:
   a case body for accommodating an electronic substrate therein; and
   a cover for closing an opening of the case body, wherein
   the connector includes:
   a terminal part for supporting a plurality of terminals; and
   a housing including a tubular part for surrounding tip end sides of the plurality of terminals,
   the terminal part and the housing are separately disposed,
   the terminal part is fixed on the electronic substrate,
   the housing is formed to be integral with the cover, and
   the terminal part and the housing are respectively provided with positioning parts for positioning the terminal part and the housing with each other.

According to the aspect of the present invention, the terminal part and the housing for the connector are separately disposed, and the housing is not formed to be integral with the case body configuring a function of the electronic component, but is formed to be integral with the cover that covers the opening of the case body for protection from an outside environment. Further, the terminal part and the housing are respectively provided with the positioning parts for the positioning with each other. As a result, separately forming the terminal part and the housing enables a reduction in costs. Since it is possible to directly position the terminal part and the housing, a reduction in positional accuracy of the terminal part and the housing can be prevented to easily secure the positional accuracy required for connection to the connector at the vehicle side. Further, since the case body is not formed to be integral with the housing, the case body can be directly positioned with respect to the electronic substrate, making it possible to prevent the reduction in the positional accuracy of the electronic component, too.

### BRIEF DESCRIPTION OF THE DRAWINGS

Other objects, features, and advantages of the present invention will become more apparent from the following detailed description made with reference to the accompanying drawings, in which like parts are designated by like reference numbers and in which:
Fig. 1 is a perspective view illustrating the configuration of an outer appearance of a switch according to an embodiment in the present invention,
Fig. 2 is an exploded perspective view illustrating the switch according to the embodiment,
Fig. 3 is an exploded cross section illustrating the switch according to the embodiment, as viewed from a direction of Y axis of the switch,
Fig. 4 is a plan view illustrating a housing formed to be integral with a cover according to the embodiment,
Fig. 5A is a perspective view illustrating a tubular part and an extension part of the switch in an assembled state of the switch according to the embodiment,
Fig. 5B is a perspective view illustrating only the extension part of the switch in the assembled state of the switch according to the embodiment,
Fig. 6 is a cross section taken along Y axis of the switch and illustrating the assemble state of the switch according to the embodiment, and
Fig. 7 is a diagram explaining the assembling of a switch provided with a conventional connector structure.

### DESCRIPTION OF THE EMBODIMENT

Hereinafter, an explanation will be made of a connector structure in a case in which a connector is attached according to an embodiment in the present invention. The case configures an electronic component, and the electronic component is not limited to a specific component, and an explanation of the embodiment will be made using an example of a switch that is installed in a vehicle.

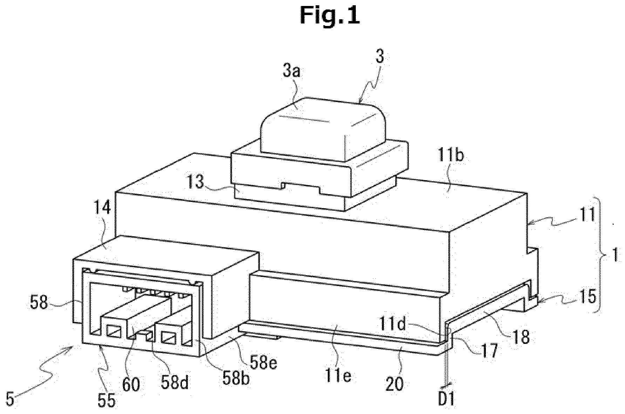

Fig. 1 is a perspective view illustrating an assembled state of a switch.

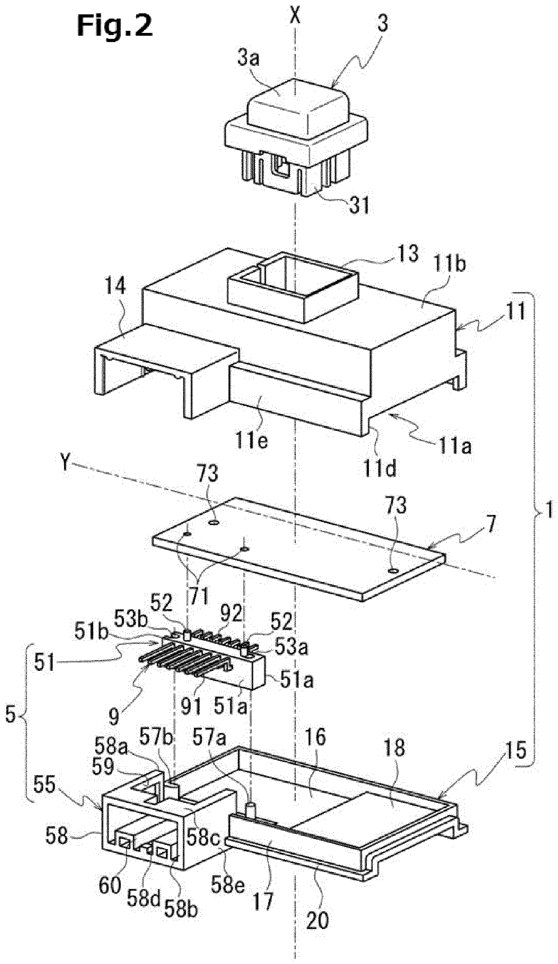

Fig. 2 is an exploded perspective view of the switch.

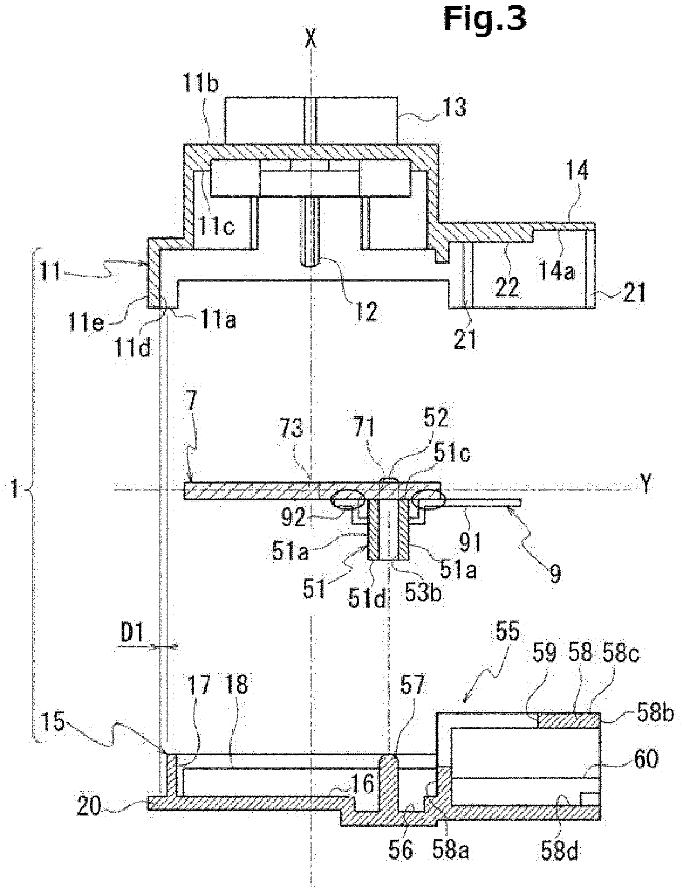

Fig. 3 is an exploded cross section illustrating the switch, as viewed from a direction of Y axis of the switch. However, in Fig. 3, illustration of a knob is omitted.

As illustrated in Fig. 1 and Fig. 2, a switch as an electronic component is provided with a case 1 that accommodates therein an electronic substrate on which switch elements and the like are installed, and a knob 3 that is held in the case 1 and switches an on/off operation of the switch. A connector 5 is attached on the case 1 to connect the switch to a power source, a control device or the like installed at a vehicle side. An explanation of the embodiment will be made using an example where the connector 5 attached on the case 1 is a male connector.

The case 1 is provided with a boxy case body 11 a lower end of which is opened, and a plate-shaped cover 15 that closes a lower end opening 11a of the case body 11. It should be noted that, for descriptive purposes, an upper side is defined as an upper direction and a lower side is defined as a lower direction in Fig. 2, and, based thereupon, a positional relation of the respective elements of the switch will be explained. In addition, an axis line along an assembling direction of the switch is defined as "axis line X" and an axis line in a direction perpendicular to the axis line X is defined as "axis line Y".

The case body 11 and the cover 15 each are formed by molding or the like. The case body 11 accommodates the electronic substrate 7 therein and is fixed on an unillustrated vehicle body (fixed member). Although unillustrated, the electronic substrate 7 is provided thereon with various components configuring the electronic component, such as switching elements, LEDs and the like. A projection 12 that is a positioning part with respect to the electronic substrate 7 is formed on an inner upper surface 11c of the case body 11 (refer to Fig. 3). In addition, the electronic substrate 7 is provided with a plurality of holes 71, 73 that are positioning parts with respect to other members including the case body 11.

A holding part 13 of the knob 3 is disposed on an outer upper surface 11b of the case body 11. The knob 3 is a tubular member an upper end of which is closed and a lower end of which is opened, and a pressing part 31 is disposed on its lower end. The pressing part 31 is formed in a position corresponding to the switching element installed on the electronic substrate 7.

The knob 3 is held in the holding part 13 of the case body 11. By pressing down an upper end surface 3a of the knob 3, the knob 3 slides toward the inside of the case body 11 to cause the pressing part 31 in the lower end of the knob 3 to press the switching element, thus switching an on/off operation of the switch. The switching element is provided with a resilient member of a rubber sheet or the like, and when the upper end surface 3a of the knob 3 is released, the knob 3 is urged by the resilient member to be returned back to an initial position.

The connector 5 is provided with a terminal part 51 for supporting a plurality of pin-shaped terminals 9 and a housing 55 for accommodating the terminal part 51 therein. The terminal part 51 and the housing 55 are separately formed, and the housing 55 is formed to be integral with the cover 15 by molding or the like.

The terminal part 51 is a rectangular terminal platform, and the plurality of pin-shaped terminals 9 arranged along the axis line Y are supported by penetration of them through side surfaces 51a, 51a, which are opposed to each other, of the terminal part 51. Projections 52, 52 are formed on an upper surface 51c of the terminal part 51 in the vicinity of both ends thereof in the axis line Y direction. The projection 52 is a positioning part with respect to the electronic substrate 7. A through hole 53a and a groove 53b are respectively formed in the vicinities of the projections 52, 52. The through hole 53a penetrates from the upper surface 51c over a lower surface 51 d of the terminal part 51. The groove 53b is formed on a side surface 51b connecting the side surfaces 51a, 51a, and extends along the axis line X from the upper surface 51c to the lower surface 51d. The through hole 53a and the groove 53b are positioning parts with the housing 55.

As illustrated in Fig. 3, both ends of the plurality of pin-shaped terminals 9 each project from the side surfaces 51a, 51a, which are opposed to each other, of the terminal part 51, are bent at the right angle toward the upper surface 51c of the terminal part 51, extend to a position of the upper surface 51c of the terminal part 51, and thereafter, extend horizontally along the axis line Y. One horizontal part 91 extending horizontally along the axis line Y is longer than the other horizontal part 92. In Fig. 3, as surrounded by circles, a base end section of each of the horizontal parts 91, 92 is earth-connected to the electronic substrate 7. A tip end of the longer horizontal part 91 projects outward from an outer edge of the electronic substrate 7, and a female connector is connected to this tip end.

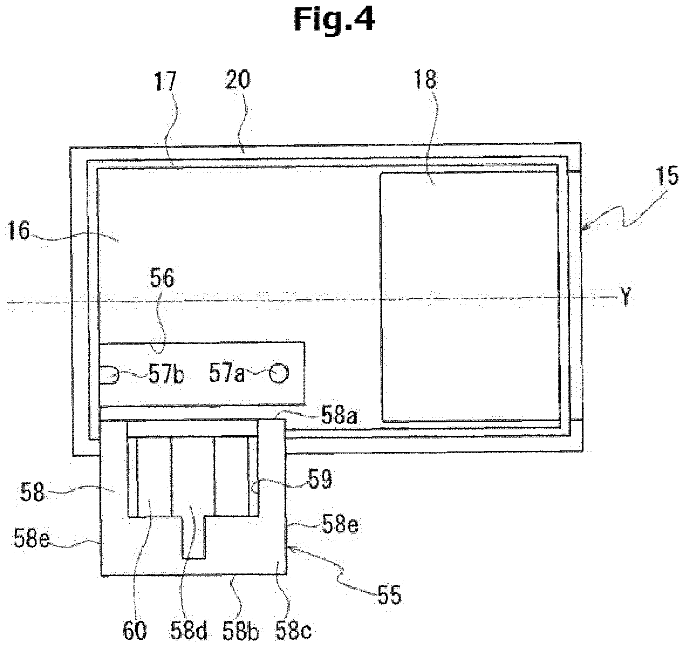

Fig. 4 is a plan view illustrating the housing formed to be integral with the cover.

As illustrated in Fig. 2 and Fig. 4, the cover 15 is provided with a rectangular flat surface part 16 that extends along the axis line Y to cover the lower end opening 11a of the case body 11, and a peripheral wall 17 that is disposed to extend upward along the axis line X from an outer edge of the flat surface part 16 and extends to the case body 11-side. A stage 18 is disposed on the flat surface part 16 to support the electronic substrate 7. Part of the electronic substrate 7 is supported on the stage 18 and the rest extends on the flat surface part 16 to face the flat surface part 16 by an interval.

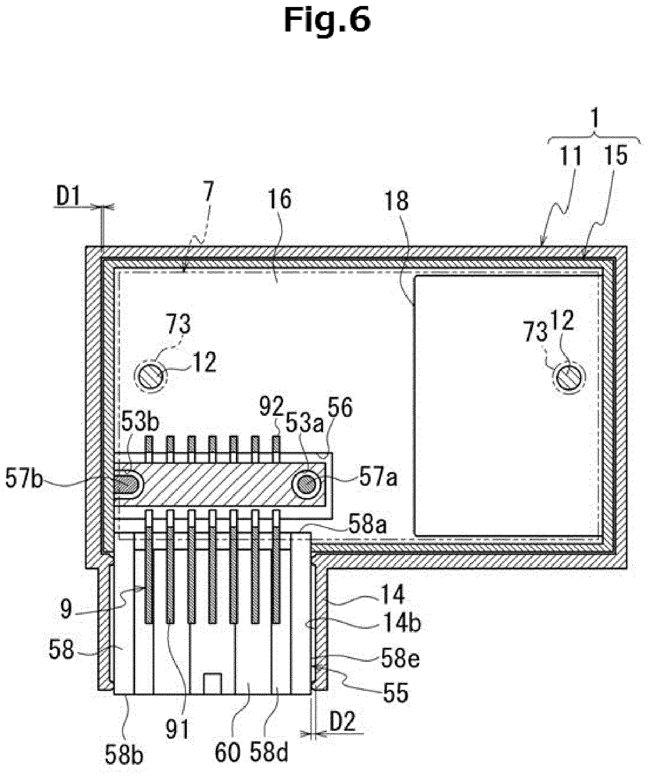

As illustrated in Fig. 1, in a state where the case body 11 and the cover 15 are assembled, the peripheral wall 17 of the cover 15 faces an inner side surface 11d of the case body 11 in the vicinity of the lower end opening 11a. Since a dimension of the outer edge of the flat surface part 16 is set to be smaller than that of an outer edge of the lower end opening 11a of the case body 11, the peripheral wall 17 of the cover 15 faces the inner side surface 11d of the case body 11 with a gap D1 (refer to Fig. 6).

A flange 20 is disposed to extend horizontally with respect to the flat surface part 16 over an entire circumference of the outer edge of the flat surface part 16 of the cover 15. As illustrated in Fig.1, the flange 20 covers the gap D1 between the inner side surface 11d of the case body 11 and the peripheral wall 17 of the cover 15. Since the flange 20 is only required to be as long as to cover the gap D1, the flange 20 may have the same dimension as an outer side surface 11e of the case body 11 or may be longer than that.

The housing 55 is provided with a support part 56 that supports the terminal part 51 and a tubular part 58 that surrounds a tip end side of the horizontal part 91 of the pin-shaped terminal 9.

The support part 56 is a recessed part formed on the flat surface part 16 of the cover 15, and the lower surface 51d of the terminal part 51 is placed and supported on the support part 56 (refer to Fig. 6). The support part 56 is provided with projections 57a, 57b that are positioning parts with respect to the terminal part 51. The projection 57b is formed in the form of swelling in the axis line Y direction from the peripheral wall 17 of the cover 15. When the projection 57a is inserted in the through hole 53a of the terminal part 51 and the projection 57b is inserted in the groove 53b, the terminal part 51 and the housing 55 are positioned.

As illustrated in Fig. 2, the tubular part 58 is formed to extend outward from the outer edge of the flat surface part 16 of the cover 15. It should be noted that the peripheral wall 17 of the cover 15 and the flange 20 as described before are formed in sections other than the tubular part 58.

A base end 58a-side, which is in contact with the outer edge of the flat surface part 16, of the tubular part 58 and a tip end 58b-side, which opposes the base end 58a, of the tubular part 58 are opened. A notch 59 is formed in the base end 58a-side of the outer upper surface 58c of the tubular part 58. At the time of assembling the terminal part 51 on the housing 55, the tip end of the horizontal part 91 of the pin-shaped terminal 9 supported by the terminal part 51 is caused to be accommodated in the inside of the tubular part 58 through the notch 59 of the tubular part 58.

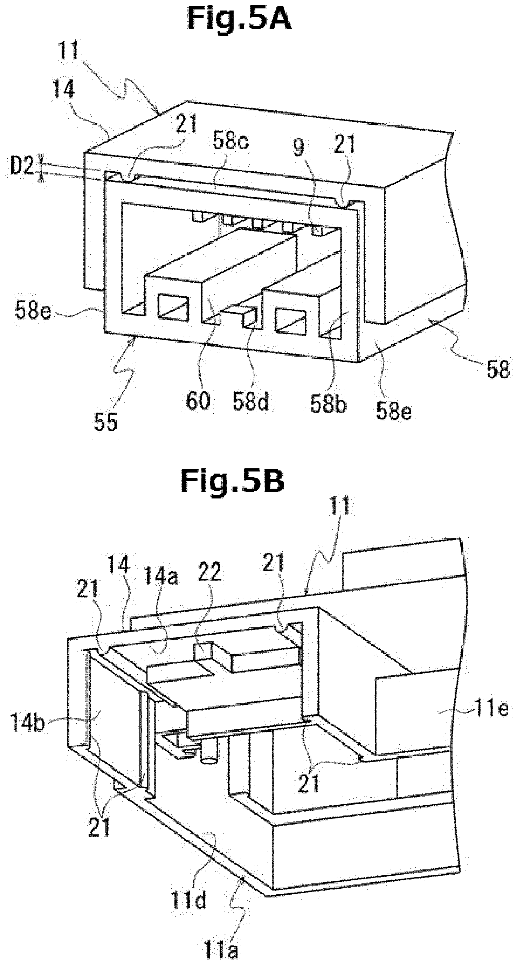

Fig. 5A is a perspective view illustrating the tubular part and the extension part in the assembling state of the switch, and Fig. 5B is a perspective view illustrating the extension part alone.

As illustrated in Fig. 5A, the periphery of the tip end of the pin-shaped terminal 9 is surrounded by the tubular part 58, but a terminal of the female connector is connectable from an exterior of the switch through the opened tip end 58b of the tubular part 58. A guide 60 is formed on an inner lower part 58d of the tubular part 58 to guide the terminal of the female connector to the pin-shaped terminal 9.

As described before, the case body 11 is formed in a boxy shape, but a section of the side surface, which faces the tubular part 58, of the housing 55 extends outward along the tubular part 58 to form an extension part 14 covering the outer periphery of the tubular part 58. The extension part 14 covers part of the exterior upper surface 58c and the exterior side surfaces 58e, 58e of the tubular part 58, and is formed in a reverse-C letter shape as viewed in section.

A dimension of the outer periphery of the tubular part 59 of the connector 5 is made smaller than a dimension of an inner periphery of the extension part 14. Therefore the extension part 14 covers the tubular part 58 through a gap D2. As illustrated in Fig. 5B, a plurality of ribs 21 are formed on an inner upper surface 14a and an inner side surface 14b configuring the inner periphery of the extension part 14. As illustrated in Fig. 5A, these ribs 21 respectively extend in the gap D2 to come in contact with the tubular part 58. A convex part 22 is formed on the inner upper surface 14a of the extension part 14 facing the outer upper surface 58c of the tubular part 58 to be fitted in the notch 59 (refer to Fig. 2) of the tubular part 58.

An explanation will be made of the assembling and the operation of the switch having the above-mentioned configuration.

As described before, the cover 15 and the housing 55 for the connector 5 are formed to be integral by molding or the like, and then, the terminal part 51 of the connector 5, the electronic substrate 7 and the case body 11 are assembled thereto. It should be noted that the knob 3 is held by the holding part 13 of the case body 11, but the details thereof are omitted.

As illustrated in Fig. 3, the terminal part 51 of the connector 5 is fixed on the electronic substrate 7 before assembling the entire switch. The projection 52 formed on the upper surface 51c of the terminal part 51 is inserted in a hole 71 of the electronic substrate 7 for the positioning.

As illustrated by the round surroundings in Fig. 3, the base end sections of the horizontal parts 91, 92 of the pin-shaped terminal 9 are fixed on the electronic substrate 7 by soldering or the like. The tip end of the longer horizontal part 91 of the pin-shaped terminal 9 is placed to extend outward from the outer edge of the electronic substrate 7.

Next, the electronic substrate 7 and the terminal part 51 that are fixed are assembled to the cover 15 and the housing 55 that are formed to be integral.

Fig. 6 is a cross section taken along a Y axis direction and illustrating the assembled state of the switch. In Fig. 6, the electronic substrate 7 is illustrated in a broken line for easy understanding.

As illustrated in Fig. 3 and Fig. 6, the projections 57, 57 disposed in the support part 56 of the housing 55 are inserted in the through hole 53a and the groove 53b formed in the terminal part 51 for the positioning. The tip end of the pin-shaped terminal 9 supported in the terminal part 51 is accommodated in the inside of the tubular part 58 through the notch 59 of the tubular part 58. Thereby the terminal part 51 and the electronic substrate 7 are assembled to the cover 15 formed to be integral with the housing 55.

Subsequently the case body 11 will be assembled to the cover 15. The projection 12 disposed on the inner upper surface 11c of the case body 11 is inserted in a hole 73 of the electronic substrate 7 to be positioned, and the convex part 22 formed on the inner upper surface 14a of the extension part 14 is fitted in the notch 59 formed in the outer upper surface 58c of the tubular part 58. Thereby the flat surface part 16 of the cover 15 is assembled to cover the lower end opening 11a of the case body 11. The extension part 14 of the case body 11 covers the tubular part 58 of the housing 55 formed to be integral with the cover 15.

That is, in the embodiment the cover 15 and the case body 11 are not assembled to be directly positioned. The cover 15 and the case body 11 are assembled to be indirectly positioned in the form where the housing 55 of the connector 5 formed to be integral with the cover 15 and the terminal part 51 are positioned and the electronic substrate 7 in advance fixed in the terminal part 51 is positioned in the case body 11. Therefore in a case where the cover 15 and the case body 11 are assembled without a gap, when the peripheral wall 17 of the cover 15 and the inner side surface 11d of the case body 11 have variations in dimension, there is a possibility that they interfere with each other to block the assembling thereof. Therefore the dimension of the peripheral wall 17 of the cover 15 is made smaller than the dimension of the inner side surface 11d of the case body 11 to cause the peripheral wall 17 of the cover 15 to face the inner side surface 11d of the case body 11 through the gap D1. Further, the flange 20 is disposed to extend outward from the outer edge of the cover 15, and by covering the gap D1 between the peripheral wall 17 and the inner side surface 11d of the case body 11 with the flange 20, dusts can be prevented from entering the gap D1.

The inner periphery of the extension 14 of the case body 11 faces the outer periphery of the tubular part 58 with the gap D2, but as illustrated in Fig. 5, the plurality of ribs 21 disposed on the inner upper surface 14a and the inner side surface 14b of the extension part 14 extend in the gap D2 to come in contact with the tubular part 58, thus acting as gap fillings. *When* some of the plurality of ribs 21 do not come in contact with the extension 14 due to a dimension tolerance, a height of each of the ribs 21 is adjusted by a metallic mold.

When the female connector at the vehicle side is inserted from the tip end 58b of the tubular part 58 of the housing 55 in the connector 5 to be connected to the pin-shaped terminal 9 of the terminal part 51, a prying force is applied on the housing 55. When the prying force is input on the terminal part 51 connected to the housing 55 by the positioning to be applied on sections (sections surrounded by circles in Fig. 3) of the terminal part 51 soldered to the electronic substrate 7, a reduction in quality of the connector 5 is possibly invited. In the embodiment, since the tubular part 58 of the housing 55 is in contact with the ribs 21, the prying force applied on the housing 55 tends to be easily scattered to the case body 11 fixed to the vehicle body through the ribs 21, making it possible to reduce the prying force that will be input to the terminal part 51.

It should be noted that, although not illustrated, a snap fit or the like may be disposed to the cover 15 and the case body 11 to fix the cover 15 to the case body 11.

As described above, the connector structure according to the embodiment is the connector structure in the case 1 in which the connector 5 is attached, wherein,
the case 1 includes:
the case body 11 for accommodating the electronic substrate 7 therein; and
the cover 15 for closing the lower end opening 11a (opening) of the case body 11,
the connector 5 includes:
   the terminal part 51 for supporting the plurality of terminals 9 (terminals); and
   the housing 55 including the tubular part 58 for surrounding tip end sides of the plurality of terminals 9,
   the terminal part 51 and the housing 55 are separately disposed,
   the terminal part 51 is fixed on the electronic substrate 7,
   the housing 55 is formed to be integral with the cover 15, and
   the terminal part 51 and the housing 55 are respectively provided with the through hole 53a and the groove 53b, and the projections 57, 57 (positioning parts) for positioning the terminal part 51 and the housing 55 with each other.

According to the conventional connector structure (refer to Fig. 7), the housing 550 of the connector 500 is formed to be integral with the case body 110. On assembling, the housing 550 and the terminal part 510 are indirectly positioned through the case body 110 and the electronic substrate 700 respectively connected thereto. As compared to a case where the housing 550 and the terminal part 510 are integrally formed, the cost can be reduced, but on assembling the whole, the positional accuracy of each possibly reduces. When the positional accuracy of the housing 550 and the terminal part 510 reduces, at the time the female connector at the vehicle side is inserted from the tip end of the tubular part of the housing 550 to be connected to the pin-shaped terminal, the positional accuracy required cannot be possibly achieved.

For enhancing the positional accuracy of the terminal part 510 and the housing 550, it is considered to cause the case body110, which has been positioned with respect to the electronic substrate 700, to be positioned directly with respect to the terminal part 510. However, in that case, there is a possibility that the positional accuracy of the case body 110 and the electronic substrate 700 is reduced to reduce positional accuracy of the electronic component of the switch or the like.

In the connector structure according to the embodiment illustrated in Fig. 1 to Fig. 6, the housing 55 of the connector 5 is not formed to be integral with the case body 11 configuring the function of the switch as the electronic component, but is formed to be integral with the cover 15 that covers the lower end opening 11a of the case body 11 for protection from the outside environment, thus directly positioning the terminal part 51 and the housing 55. Thereby the terminal part 51 and the housing 55 are separately formed to reduce the cost while being capable of preventing the reduction in positional accuracy of the terminal part 51 and the housing 55. Thereby the positional accuracy required in the connection to the connector 5 at the vehicle side is more likely to be secured. Further, since the case body 11 is not formed to be integral with the housing 55, the case body 11 can be directly positioned with respect to the electronic substrate 7, also preventing a reduction in positional accuracy of the electronic component.

It should be noted that in the embodiment, the example of using the through hole 53a and the terminal part 51 and the groove 53b, and the projections 57, 57 as the positioning parts of the terminal part 51 and the housing 55 is explained, but the positioning part is only required to be capable of positioning the respective members with respect to each other, and the configuration and the disposed position can be changed as needed. Also as to the positioning part of the other member, the configuration and the disposed position are not limited to specific ones.
(2) The case body 11 is fixed on the vehicle body (fixed member) and is provided with the extension part 14 for covering at least part of the outer periphery of the tubular part 58 of the housing 55, and the inner upper surface 11c and the inner side surface 11d (inner periphery), which face the outer periphery of the housing 55 through the gap D2, of the extension part 14 are provided with the ribs 21 (projections) in contact with the outer periphery of the tubular part 58 of the housing 55.

When the female connector at the vehicle side is inserted from the tip end of the tubular part 58 of the housing 55 of the connector 5 to be connected to the pin-shaped terminal 9 of the terminal part 51, the prying force is applied on the housing 55, but the tubular part 58 of the housing 55 comes in contact with the ribs 21 to act as the gap fillings. Thereby the prying force applied to the housing 55 tends to be easily scattered to the case body 11 fixed on the vehicle body through the ribs 21. Thereby it is possible to reduce the prying force that is input to the terminal part 51 to be applied to the section of the terminal part 51 and the electronic substrate 7 fixed by soldering, making it possible to prevent the reduction in quality of the connector 5. In addition, when some of the ribs 21 do not come in contact with the outer periphery of the extension part 14 due to the dimension tolerance, the height of each of the ribs 21 can be adjusted by the metallic molding.

It should be noted that in the embodiment, the example of disposing the ribs 21 on the inner periphery of the extension part 14 is explained as an example of the projection, but the projection is not limited to this example. The projection is only required to project from somewhere of the inner periphery of the extension part 14 or the outer periphery of the tubular part 58 to cause the inner periphery of the extension part 14 to come in contact with the outer periphery of the tubular part 58. For example, a projection in a semispherical shape may be disposed as the projection. In addition, the projection is not disposed on the inner peripheral side of the extension part 14, but may be disposed on the outer peripheral side of the tubular part 58.
(3) The cover 15 is provided with the flat surface part 16 that covers the lower end opening 11a of the case body 11, the peripheral wall 17 that extends to the case body 11-side from the outer edge of the flat surface part 16 and faces the inner side surface 11d (inner periphery) of the case body 11 with the gap D1, and the flange 20 that is disposed over the entire circumference of the outer edge of the flat surface part 16 and extends in the horizontal direction with respect to the flat surface part 16 to cover the gap D1 between the inner side surface 11d of the case body 11 and the peripheral wall 17 of the cover 15.

In the embodiment the cover 15 and the case body 11 are not directly positioned. Therefore in a case where the cover 15 and the case body 11 are to be assembled without a gap, when the peripheral wall 17 disposed to rise in the upward direction from the outer edge of the cover 15 and the inner side surface 11d of the case body 11 have variations in dimension, there is a possibility that the cover 15 and the case body 11 interfere with each other to block the assembling thereof. Therefore, the gap D1 is provided between the peripheral wall 17 of the cover 15 and the inner side surface 11d of the case body 11 to prevent the interference between the cover 15 and the case body 11. Further, the flange 20 is disposed to extend outward from the outer edge of the cover 15, and by covering the gap D1 between the peripheral wall 17 and inner side surface 11d of the case body 11 with the flange 20, dusts can be prevented from entering the gap D1.

While only the selected embodiment has been chosen to illustrate the present invention, it will be apparent to those skilled in the art from this disclosure that various changes and modifications can be made therein without departing from the scope of the invention as defined in the appended claims. Furthermore, the foregoing description of the embodiment according to the present invention is provided for illustration only, and not for the purpose of limiting the invention as defined by the appended claims and their equivalents.

### Description of Reference Numerals

1 CASE
3 KNOB
3a UPPER END SURFACE
5 CONNECTOR
7 ELECTRONIC SUBSTRATE
9 PIN-SHAPED TERMINAL
11 CASE BODY
11a LOWER END OPENING
11b OUTER UPPER SURFACE
11c INNER UPPER SURFACE
11d INNER SIDE SURFACE
11 e OUTER SIDE SURFACE
12 PROJECTION
13 HOLDING PART
14 EXTENSION PART
14a INNER UPPER SURFACE
14b INNER SIDE SURFACE
15 COVER
16 FLAT SURFACE PART
17 PERIPHERAL WALL
18 STAGE
20 FLANGE
21 RIB
22 CONVEX PART
31 PRESSING PART
51 TERMINAL PART
51a, 51a SIDE SURFACE
51b SIDE SURFACE
51c UPPER SURFACE
51d LOWER SURFACE
52 PROJECTION
53a THROUGH HOLE
53b GROOVE
55 HOUSING
56 SUPPORT PART
57 PROJECTION
58 TUBULAR PART
58a BASE END
58b TIP END
58c OUTER UPPER SURFACE
58d INNER LOWER SURFACE
58e OUTER SIDE SURFACE
59 NOTCH
60 GUIDE
71, 73 HOLE
91, 92 HORIZONTAL PART
D1, D2 GAP

## Claims

1. A connector structure in a case (1) in which a connector (5) is attached, wherein
the case (1) includes:
a case body (11) for accommodating an electronic substrate (7) therein; and
a cover (15) for closing an opening of the case body (11),
the connector includes:
a terminal part (51) for supporting a plurality of terminals; and
a housing (55) including a tubular part (58) for surrounding tip end sides (58a) of the plurality of terminals,
the terminal part (51) and the housing (55) are separately disposed,
the terminal part (51) is fixed on the electronic substrate (7),
the housing (55) is formed to be integral with the cover (15), and
the terminal part (51) and the housing (55) are respectively provided with positioning parts for positioning the terminal part (51) and the housing (55) with each other.

2. The connector structure according to claim 1, wherein
the case body (11) includes an extension part (14) that is fixed on a fixed member and covers at least part of an outer periphery of the housing (55), and
an inner periphery of the extension part (14) or the outer periphery of the housing (55) facing the inner periphery of the extension part through a gap (D1, D2) includes a projection (12) causing the inner periphery of the extension part (14) to be in contact with the outer periphery of the housing (55).

3. The connector structure according to claim 1, wherein
the cover (15) includes:
a flat surface part (16) that covers an opening of the case body (11);
a peripheral wall (17) that extends to the case body side from an outer edge of the flat surface part (16) and faces an inner periphery of the case body (11) through a gap (D1, D2); and
a flange (20) that is disposed over an entire circumference of the outer edge of the flat surface part (16) and extends in a horizontal direction with respect to the flat surface part (16) to cover the gap (D1, D2) between the inner periphery of the case body (11) and the peripheral wall of the cover (15).
